# EUROPÄISCHE PATENTSCHRIFT

(11) **EP 1 380 058 B1**
(45) Veröffentlichungstag und Bekanntmachung des Hinweises auf die Patenterteilung: **23.07.2008**
(21) Anmeldenummer: 02730028.4
(22) Anmeldetag: 19.03.2002
(51) Int. Cl.: H01L 39/14

(54) **SUPRALEITERANORDNUNG**
SUPERCONDUCTOR ASSEMBLY
ENSEMBLE SUPRACONDUCTEUR

(30) Priorität: 06.04.2001 DE 10117370
(43) Veröffentlichungstag der Anmeldung: 14.01.2004
(73) Patentinhaber: Vacuumschmelze GmbH & Co. KG, 63450 Hanau (DE)
(72) Erfinder: ARNDT, Thomas, J., 63454 Hanau (DE); FISCHER, Bernhard, 42109 Wuppertal (DE); MUNZ, Martin, 63755 Alzenau (DE); SZULCZYK, Andreas, 63589 Linsengericht (DE); THÖNER, Manfred, 63599 Biebergem.B. (DE)
(74) Vertreter: Schmuckermaier, Bernhard
(86) Internationale Anmeldenummer: PCT/EP2002/003031
(87) Internationale Veröffentlichungsnummer: WO 2002/082559

(56) Entgegenhaltungen:
- ONISHI T ET AL: "Improvement of stabilized current density in superconducting composite conductor" ADVANCES IN SUPERCONDUCTIVITY XI. PROCEEDINGS OF THE 11TH INTERNATIONAL SYMPOSIUM ON SUPERCONDUCTIVITY (ISS'98), FUKUOKA, JAPAN, 16. - 19. November 1998, Seiten 1381-1384 vol.2, XP001121175 Springer-Verlag, Japan ISBN: 4-431-70256-3
- APPERLEY M H ET AL: "Properties of Ag-Mg alloy sheathed Bi-2223 tapes" CRYOGENICS, Bd. 40, Nr. 4-5, April 2000 (2000-04), Seiten 319-324, XP004218757 ISSN: 0011-2275
- PATENT ABSTRACTS OF JAPAN vol. 1995, no. 03, 28. April 1995 (1995-04-28) & JP 06 349628 A (HITACHI LTD), 22. Dezember 1994 (1994-12-22) -& JP 06 349628 A (HITACHI LTD) 22. Dezember 1994 (1994-12-22)
- PATENT ABSTRACTS OF JAPAN vol. 018, no. 681 (E-1649), 21. Dezember 1994 (1994-12-21) & JP 06 275146 A (HITACHI LTD), 30. September 1994 (1994-09-30) -& JP 06 275146 A (HITACHI LTD) 30. September 1994 (1994-09-30)

## Beschreibung

Die Erfindung betrifft eine Supraleiteranordnung.

Die Bedeutung von Supraleitern nimmt ständig zu, da in immer mehr Anwendungsfällen hochstromtragfähige Leiter auch in hohen magnetischen Feldern gewünscht werden. Bekannt sind dabei zum einen metallische Supraleiter wie beispielsweise die von der Vacuumschmelze vertriebenen Supraleiter des Typs NSTT62000 oder keramische Supraleiter (auch Hochtemperatursupraleiter genannt) wie beispielsweise die von der Vacuumschmelze vertriebenen Supraleiter des Typs Bi-2223HTSL 121-2.3/-AgAgMg.

Die metallischen Supraleiter sind aufgrund ihres geringen intrinsischen spezifischen oberen kritischen Magnetfeldes nicht in der Lage in größeren Magnetfeldern noch technisch ausreichen hohe Ströme zu tragen. Die keramischen Supraleiter haben aufgrund ihres oberen kritischen Magnetfeldes, das weit größer ist als die zurzeit dauerhaft zugänglichen Magnetfelder, keine derartige Beschränkung. Der Wert des kritischen Stromes ist oberhalb von beispielsweise 20 T nahezu unabhängig vom äußeren Magnetfeld. Allerdings reagieren die keramischen Supraleiter empfindlicher auf mechanische Belastungen, die in Magneten beispielsweise durch die Lorentz-Kraft hervorgerufen werden. Aus diesem Grunde werden häufig Magnetsysteme segmentiert in ein inneres Hochfeldsegment und ein äußeres Segment. Dabei werden für das innere Hochfeldsegment keramische Supraleiter verwendet, während für die äußeren Segmente metallische Supraleiter Anwendung finden. Die beiden Supraleiterarten befinden sich bei bekannten Anordnungen jedoch nicht in direktem Kontakt, sondern sind durch Kühlmittel voneinander getrennt (JP 06-349 628) oder lediglich über eine Metallhülle des keramischen Supraleiters verbunden (JP 06-275 146). Problematisch ist dabei, zwischen den einzelnen Segmenten und damit zwischen metallischem Supraleiter und keramischem Supraleiter einen robusten verlustarmen Kontakt herzustellen.

Ansätze für einen robusten und verlustarmen Kontakt zwischen unterschiedlichen Arten von Supraleitern findet man in Onishi T. et al, Advanced Superconductor XI, Proceedings ISS'98, Vol. 2, Seiten 1381-1384. In der dort beschriebenen experimentellen Hybridsupraleiteranordnung sind Drähte eines metallischen Supraleiters auf ein Band eines keramischen Supraleiters gelötet.

Aufgabe der Erfindung ist es daher, eine Supraleiteranordnung anzugeben, die diese Nachteile nicht aufweist.

Die Aufgabe wird gelöst durch eine Supraleiteranordnung gemäß Patentanspruch 1. Ausgestaltungen und Weiterbildungen des Erfindungsgedanken sind Gegenstand von Unteransprüchen.

Vorteil der vorliegenden Erfindung ist es, dass der aus einem metallischen und einem keramischen Supraleiter zusammengesetzte "monolithische" Supraleiter zum einen die mechanische Eigenschaften und die Stromtragfähigkeit der metallischen Supraleiter bei niedrigen Magnetfeldern ausnutzt und zum anderen bei höheren Magnetfeldern sich wie ein keramischer Supraleiter verhält.

Erreicht wird dies im einzelnen durch eine Supraleiteranordnung mit einem metallischen Supraleiter und einem keramischen Supraleiter, die einen einstückigen Hybrid-Supraleiter bildend mechanisch und elektrisch miteinander verbunden sind. Das bedeutet, dass die beiden Supraleiter (insbesondere Verbundsupraleiter) nicht nur an den Enden miteinander verbunden sind, sondern punktuell oder durchgehend über die ganze Supraleiterlänge mechanisch und elektrisch miteinander in Verbindung stehen, wobei die beiden Supraleiter jeweils einen rechteckigen Querschnitt mit gleichen kürzeren Kantenlängen aufweisen.

Bevorzugt werden dabei die beiden Supraleiter mittels Niedertemperaturlot miteinander verbunden. Bei bestimmen Anwendungsfällen ist auch ein Verbinden mit Hartlot, leitfähigem Kunststoff (insbesondere Kleber) oder mechanischen Verbindungselementen (zum Beispiel Klammern, Formelementen, geeigneten Profilen sowie einer speziellen Formgebung der Supraleiter etc.) möglich.

Weiterhin werden beide Supraleiter jeweils als Bänder ausgebildet. Durch die (angepassten) rechteckigen Querschnitte der Leiter wird eine größere Kontaktoberfläche bereitgestellt. Diese führt zu größerer mechanischer Festigkeit der Verbindung und zu einem geringeren elektrischen Widerstand.

Bei zahlreichen Anwendungen von Supraleitern sind diese beispielsweise um einen Kern oder einen Träger gewickelt. Somit ergibt sich dass die gewickelten Supraleiter gekrümmt sind. In Weiterbildung der Erfindung hat bei einer erfindungsgemäßen gekrümmten Supraleiteranordnung der metallische Supraleiter einen größeren Krümmungsradius und der keramische Supraleiter einen demgegenüber geringeren Krümmungsradius.

Bei hinreichender mechanischer Festigkeit der (Löt-) Verbindung ist dabei auch eine Umkehrung der Lage des metallischen und des keramischen Supraleiters möglich: keramischer Supraleiter auf größerem Krümmungsradius und metallischer Supraleiter auf kleinerem Krümmungsradius. Darüber hinaus besteht auch die Möglichkeit, die beiden Supraleiter nebeneinander anzuordnen.

Als bevorzugter metallischer Supraleiter wird eine A15-Verbindung vorgesehen. Als derartiger Supraleiter kann ein quarternärer nach außen stabilisierter NbSn-Supraleiter vorgesehen werden, der 20%-40% Kupfer (insbesondere 22%-24% Kupfer) enthalten kann. Der NbSn-Supraleiter kann auch durch andere metallische Hochmagnetfeldleiter, wie zum Beispiel NbAl-Supraleiter, ersetzt werden.

Als keramische Supraleiter werden vorzugsweise (Bi,Pb)₂Sr₂Ca₂Cu₃Oₓ-Supraleiter vorgesehen. Diese supraleitenden Metalloxidverbindungen weisen hohe Sprungtemperaturen von mindestens 77K auf, weshalb diese Verbindungen auch als Hochtemperatursupraleitermaterialien bezeichnet werden und eine Kühlung durch flüssigen Stickstoff ermöglichen. Unter diese Metalloxidverbindungen fallen insbesondere Kuprate auf Basis des Wismut-Stoff systems Bi-Sr-Ca-Cu-O, wobei einzelne Komponenten dieses Stoffsystems zumindest teilweise durch andere ersetzt sein können. Insbesondere ist eine entsprechende teilweise Substitution der Bi-Komponente durch Pb möglich. Innerhalb dieser Bi-haltigen Stoffsysteme treten mindestens zwei supraleitende Phasen auf, die sich durch die Anzahl der Kupfer-Sauerstoff-Netzebenen (-Schichten) innerhalb ihrer kristallinen Einheitszellen unterscheiden. Im Allgemeinen ist aber eine Verwendung aller keramischen Hochtemperatursupraleiter denkbar wie beispielsweise:

(La,Ba)₂CuO₄;

(Nd,Ce)₂CuO_{x;}

(Nd,Sr,Ce)₂CuO₄;

HgBa₂CuOₓ;

(Pb,Cu)(Eu,Ce)₂(Sr,Eu)₂Cu₂O₉;

(Eu,Ce)₂(Ba,Eu)₂Cu₃Oₓ;

(Tl,Pb)Sr₄Cu₂CO₃O₇;

Tl₂Ba₂CuO₆;

Bi₂Sr₂(Gd,Ce)₂Cu₂O₁₀

Pb₂(Sr,La)₂Cu₂O₆;

(La,Sr,Ca)₃Cu₂O₆;

TlBa₂CaCu₂Oₓ;

YBa₂Cu₃Oₓ;

Tl₂Ba₂CaCu₂O₈;

YBa₂Cu₄O₈;

Y₂Ba₄Cu₇O₁₅;

Pb₂Sr₂YCu₃O₈;

PbBaYSrCu₃O₈;

TlBa₂Ca₂Cu₃Oₓ;

Tl₂Ba₂Ca₂Cu₃O₁₀;

(Sr,Ca)₅Cu₅O₁₀;

TlBa₂Ca₃Cu₄O₁₁;

Tl₂Ba₂Ca₃Cu₄O₁₂;

TlBa₂Ca₄Cu₅O₁₃;

Tl₂Ba₂Ca₄Cu₅O₄₁;

(Ba,Sr)CuO₂.

Einige Elemente können zur verbesserten Phasenbildung auch durch andere Metalle (zum Beispiel Pb) ersetzt sein oder der Sauerstoffgehalt kann variieren.

Bündelt man in an sich bekannter Weise mehrere entsprechende band- oder drahtförmige Hochtemperatursupraleiter oder deren Leiterzwischenprodukte oder Leitervorprodukte, so kann man auch Leiter mit mehreren supraleitenden Leiterkernen, sogenannte Mehrkern- oder Multifilamentleiter erhalten. Diese Filamente werden in eine Matrix eingebettet, die in Weiterbildung der Erfindung bevorzugt aus Silber besteht. Die Matrix kann dabei von einer dispersionsgehärteten Silber-Magnesium-Hülle umschlossen sein. Diese Hülle verschafft dem Multifilamentleiter eine Verbesserung der mechanischen Eigenschaften gegenüber einer Reinsilberhülle. Die charakteristischen Werte von Zugspannung und Dehnung und Krümmungsradius werden dabei für eine Degradation des kritischen Stromes erhöht.

Bei metallischen Supraleitern kann man zum Beispiel alternativ die von VAC vertriebenen Typen NSTxxxxx (xxxxx ist die variable Filamentzahl beispielsweise zwischen 00001 und 64000) verwenden. Bei den keramischen Supraleitern kann man zum Beispiel alternativ die von der Vacuumschmelze vertriebenen Typen mit 37, 55, 81, 121 oder mehr Filamenten verwenden. Als Matrix kann man auch eine Ag-Legierung anstatt Reinsilber verwenden (zum Beispiel AgPdₓ oder AgAuₓ). Als Hülle kann man alternativ zum Beispiel auch eine AgMn-Legierung oder eine AgMgNi-Legierung verwenden.

Die Erfindung wird nachfolgend anhand der in den Figuren der Zeichnung dargestellten Ausführungsbeispiele näher erläutert. Es zeigt:
- Fig. 1: ein Ausführungsbeispiel eines metallischen Supraleiters zur Anwendung bei einer erfindungsgemäßen Supraleiteranordnung,
- Fig. 2: eine Ausführungsform eines keramischen Supraleiters zur Verwendung bei einer erfindungsgemäßen Supraleiteranordnung,
- Fig. 3: schematisch den Aufbau einer Supraleiteranordnung im Querschnitt,
- Fig. 4: ein Ausführungsbeispiel zu einer bevorzugten Ausführungsform einer erfindungsgemäßen Supraleiteranordnung in Seitenansicht und
- Fig. 5: den Verlauf der Stromtragfähigkeit für einen einzelnen metallischen Supraleiter, einen keramischen Supraleiter und einer erfindungsgemäßen Supraleiteranordnung im Vergleich.

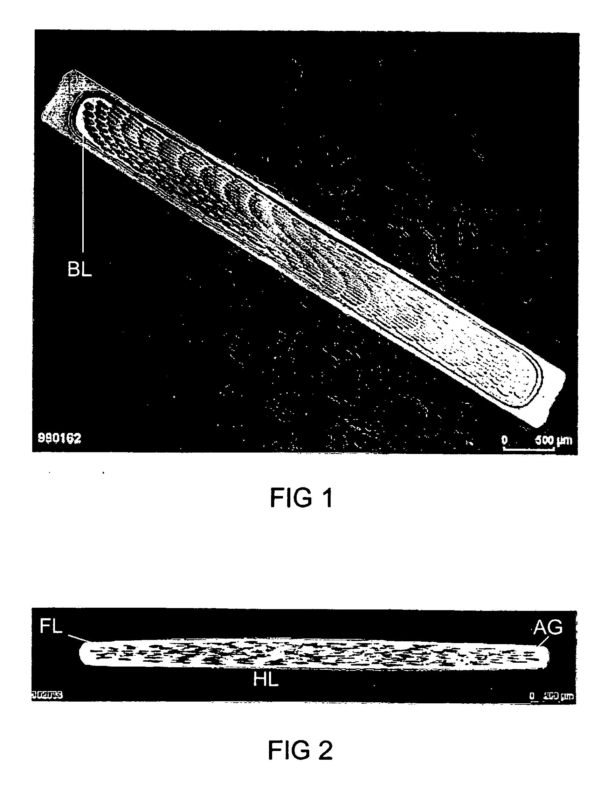

In Fig. 1 ist im Querschnitt ein konventioneller, technischer, metallischer Supraleiter des von der Vacuumschmelze vertriebenen Typs NSTT62000A23 gezeigt. Dieser Verbund-Supraleiter stellt einen quaternären, außenstabilisierten Bronze-Leiter BL mit 23 % Kupfer dar, dessen Aufbau zusammen mit der bei der Herstellung verwendeten Wärmebehandlung für den Hochfeld-Einsatz optimiert ist.

In Fig. 2 ist im Querschnitt ein keramischer Supraleiter (Hochtemperatursupraleiter) des von der Vacuumschmelze vertriebenen Typs Bi-2223 HTSL 121-2.3/-AgAgMg dargestellt. Dieser Supraleiter enthält in 121 Filamenten FL ein reagiertes Hochtemperatursupraleiterkuprat des Typs Bi-2223. Im Einzelnen wird als Kuprat Bi₂Sr₂Ca₂Cu₃Oₓ verwendet, wobei Wismut zum Teil durch Blei ersetzt werden kann. Diese Filamente FL sind in einer Matrix AG aus Silber eingebettet, die wiederum von einer dispersionsgehärteten Silber-Magnesium-Hülle HL umschlossen wird. Ein solcher keramischer Verbund-Supraleiter besitzt beispielsweise einen kritischen Strom I_{C} = 55 - 80 A bei einer Temperatur von T = 77K, einem elektrischen Feld E_{C} = 1 µV/cm im Eigenmagnetfeld.

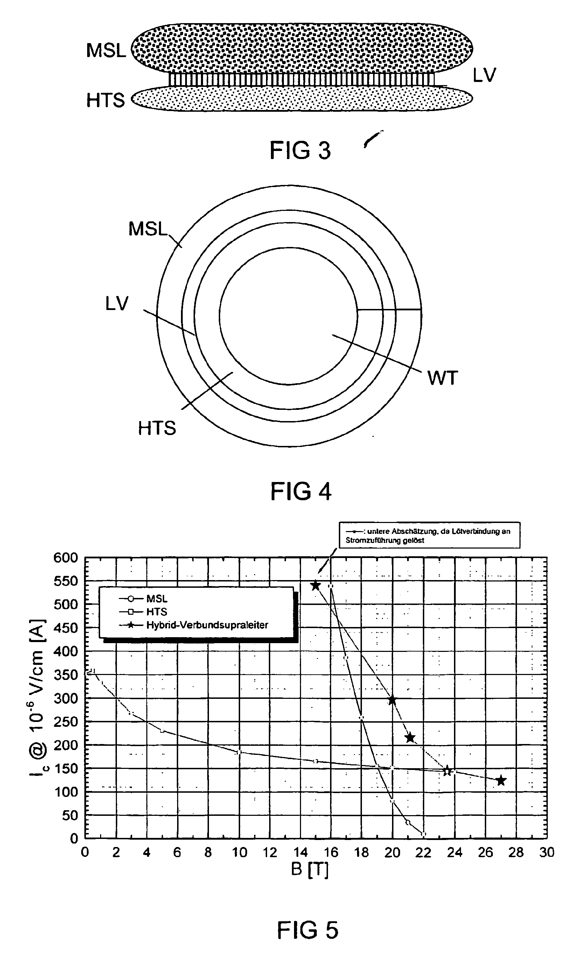

Wie in Fig. 3 gezeigt sind ein metallischer Supraleiter MSL, wie beispielsweise der in Fig. 1 dargestellte, und ein keramischer Supraleiter HTS, wie beispielsweise der in Fig. 2 dargestellte, über eine Lotverbindung LV mechanisch und elektrisch miteinander verbunden. Als Lot kommt beispielsweise niederschmelzendes, kommerziell erhältliches Lot des Typs ELSOLD Weichlot S-Bi50, Pb25Sn12,5Cd12,5 oder α-Grillo-Lötzinn Ni49In21Pb18Sn12 oder Fusion Solder Paste SSX-430-830 o. ä. zum Einsatz.

Zum Löten der beiden Supraleiter MSL und HTS wird das Lot LV beispielsweise als Paste zwischen die beiden Schichten gebracht und anschließend die gesamte Anordnung entsprechend erhitzt. Eine andere Möglichkeit besteht darin, ein flüssiges Lot LV zwischen die erhitzten Supraleiter MSL und HTSL zu gießen. Es ist auch eine Hartlötung mit einer NiCoSn-Folie möglich.

In Fig. 4 ist in Seitenansicht eine mit einer erfindungsgemäßen Supraleiteranordnung gebildete Wicklung gezeigt. Die Wicklung ist dabei auf einen Wicklungsträger WT aufgebracht. Wicklungsträger WT sowie Supraleiteranordnung sind im Wesentlichen rund, so dass die Supraleiteranordnung eine entsprechende Krümmung aufweist. Dabei ist der keramische Supraleiter HTS beispielsweise näher zum Träger WT angeordnet als der metallische Supraleiter MSL.

In Fig. 5 ist die Stromtragfähigkeit eines einzelnen metallischen Supraleiters MSL, eines keramischen Supraleiters HTSL und eines Hybrid-Verbundsupraleiters gemäß der Erfindung im Vergleich dargestellt. Der Verlauf des keramischen Supraleiters HTS ist dabei ausgehend von hohen Stromdichten I_{C} (in A) und kleinen magnetischen Flüssen B (in T) zunächst steiler fallend und geht dann in flacherem Verlauf zu kleineren Stromdichten über. Dagegen beginnt der Verlauf des metallischen Supraleiters MSL beginnend bei mittleren Magnetflüssen B und hohen Stromdichten und geht praktisch gegen Null bei hohen Magnetflüssen B, wobei der Verlauf wesentlich steiler ist.

Daraus ist zu ersehen, dass die metallischen Supraleiter MSL nicht in der Lage sind, in größeren Magnetfeldern noch technisch ausreichend hohe Ströme zu tragen. Die keramischen Supraleiter HTS haben dagegen keine derartige Beschränkung. Der Wert des kritischen Stromes ist bei keramischen Supraleitern oberhalb von beispielsweise 20 T nahezu unabhängig vom äußeren Magnetfeld. Allerdings reagieren die keramischen Supraleiter empfindlicher auf mechanische Belastungen, die etwa in Magnetendachsen und durch die Lorentz-Kraft hervorgerufen werden.

Die vorliegende Erfindung reduziert diese Problematiken erheblich, indem sie metallischen Supraleiter MSL und keramischen Supraleiter HTS zu einem Monolith-Leiter derart verbindet, dass die Stromtragfähigkeit der metallischen Supraleiter MSL bei niedrigen Magnetfeldern ausgenutzt wird und bei höheren Magnetfeldern dann die Stromtragfähigkeit der keramischen Supraleiter HTS genutzt wird.

Ein weiterer Vorteil dabei ist, dass das Maximum der Kraftbelastung (Lorentz-Kraft) nun nicht mehr in den höchsten Feldern (> 20 T), sondern bei ca. 15 T auftritt. Wie aus Fig. 5 zu ersehen ist, gestaltet sich der Ic(B)-Verlauf beim Hybrid-Verbundsupraleiter derart, dass er bei stärkeren Magnetfeldern nicht gegen Null geht, sondern von größeren Strömen her in den Verlauf des keramischen Supraleiters HTS einschwenkt.

## Patentansprüche

1. Supraleiteranordnung mit einem als Band ausgebildeten metallischen Supraleiter (MSL) und einem eine Metalloxidverbindung aufweisenden und als Band ausgebildeten keramischen Supraleiter (HTS), die einen einstückigen Hybridsupraleiter ergebend mechanisch und elektrisch über zumindest ein Material, das unterschiedlich zu den Materialien der beiden Supraleiter (MSL, HTS) ausgeführt ist, miteinander verbunden sind, **dadurch gekennzeichnet, dass** die beiden Supraleiter (MSL, HTS) jeweils einen rechteckigen Querschnitt aufweisen, wobei die längeren Kantenlängen der rechteckigen Querschnitte der beiden Supraleiter (MSL, HTS) gleich sind.

2. Supraleiteranordnung nach Anspruch 1, bei der die beiden Supraleiter (MSL, HTS) mittels Niedertemperaturlot (LV) miteinander verbunden sind.

3. Supraleiteranordnung nach einem der vorherigen Ansprüche, bei der die beiden miteinander verbundenen Supraleiter (MSL, HTS) gekrümmt sind, wobei der metallische Supraleiter (MSL) einen größeren Krümmungsradius aufweist als der keramische Supraleiter (HTS) oder umgekehrt.

4. Supraleiteranordnung nach einem der vorherigen Ansprüche, bei der als metallischer Supraleiter (MSL) eine A15-Verbindung vorgesehen ist.

5. Supraleiteranordnung nach Anspruch 4, bei der als NbSn-Supraleiter ein quaternärer, außenstabilisierter Bronze-Leiter vorgesehen ist.

6. Supraleiteranordnung nach Anspruch 5, bei der der Bronze-Leiter 20 bis 40 Prozent Kupfer enthält.

7. Supraleiteranordnung nach einem der vorherigen Ansprüche, bei der als keramischer Supraleiter (HTS) ein (Bi, Pb)₂Sr₂Ca₂Cu₃Oₓ-Supraleiter vorgesehen ist.

8. Supraleiteranordnung nach Anspruch 7, bei der der keramische Supraleiter (HTS) mehrere Filamente (FL) aufweist, die in eine Matrix (AG) aus Silber eingebettet sind.

9. Supraleiteranordnung nach Anspruch 8, bei der die Matrix (AG) von einer dispersionsgehärteten Silber-Magnesium-Hülle (HL) umschlossen ist.

## Claims

1. A superconductor assembly including a metallic superconductor (MSL) in the form of a strip and a ceramic superconductor (HTS), which is in the form of a strip and includes a metal oxide compound, which are connected together mechanically and electrically to produce an integral hybrid superconductor by means of at least one material, which is different to the materials of the two superconductors (MSL, HTS), **characterised in that** the two superconductors (MSL, HTS) each have a rectangular cross-section, wherein the longer edges of the rectangular cross-sections of the two superconductors (MSL, HTS) are of the same length.

2. A superconductor assembly as claimed in Claim 1, in which the two superconductors (MSL, HTS) are connected together by means of low temperature solder (LV).

3. A superconductor assembly as claimed in one of the preceding claims, in which the two superconductors (MSL, HTS) connected together are curved, wherein the metallic superconductor (MSL) has a larger radius of curvature than the ceramic superconductor (HTS) or vice versa.

4. A superconductor assembly as claimed in one of the preceding claims, in which an A15 compound is provided as the metallic superconductor (MSL).

5. A superconductor assembly as claimed in Claim 4, in which a quaternary, externally stabilised bronze conductor is provided as an NbSn superconductor.

6. A superconductor assembly as claimed in Claim 5, in which the bronze conductor contains 20 to 40 percent copper.

7. A superconductor assembly as claimed in one of the preceding claims, in which a (Bi, Pb)₂Sr₂Ca₂Cu₃Oₓ superconductor is provided as the ceramic superconductor (HTS).

8. A superconductor assembly as claimed in Claim 7, in which the ceramic superconductor (HTS) has a plurality of filaments (FL), which are embedded in a matrix (AG) of silver.

9. A superconductor assembly as claimed in Claim 8, in which the matrix (AG) is surrounded by a dispersion hardened silver-magnesium sheath (HL).

## Revendications

1. Dispositif supraconducteur comportant un supraconducteur métallique (MSL) en forme de ruban et un supraconducteur céramique (HTS) ayant une combinaison oxyde-métal et réalisé sous la forme d'un ruban, pour former un supraconducteur hybride en une seule pièce, combiné mécaniquement et électriquement par au moins un matériau différent des matériaux des deux supraconducteurs (MSL, HTS),
**caractérisé en ce que**
les deux supraconducteurs (MSL, HTS) ont chacun une section rectangulaire,
les longueurs d'arêtes les plus grandes de la section rectangulaire des deux supraconducteurs (MSL, HTS) étant égales.

2. Dispositif supraconducteur selon la revendication 1 dans lequel les deux supraconducteurs (MSL, HTS) sont reliés l'un à l'autre par une soudure basse température (LV).

3. Dispositif supraconducteur selon l'une des revendications précédentes, dans lequel les deux supraconducteurs (MSL, HTS), reliés l'un à l'autre sont cintrés, le supraconducteur métallique (MSL) ayant un rayon de courbure plus grand que le supraconducteur céramique (HTS) ou inversement.

4. Dispositif supraconducteur selon l'une des revendications précédentes, selon lequel le supraconducteur métallique (MSL) comporte une liaison A 15.

5. Dispositif supraconducteur selon l'une des revendications précédentes, selon lequel le supraconducteur NbSn est un conducteur quaternaire en bronze à stabilisation extérieure.

6. Dispositif supraconducteur selon la revendication 5, selon lequel le conducteur en bronze contient entre 20 % et 40 % de cuivre.

7. Dispositif supraconducteur selon l'une des revendications précédentes, selon lequel le supraconducteur céramique (HTS) est un supraconducteur (Bi, Pb) ₂Sr₂Ca₂Cu₃Oₓ.

8. Dispositif supraconducteur selon la revendication 7, selon lequel le supraconducteur céramique (HTS) comporte plusieurs filaments (FL) intégrés dans une matrice (AG) en argent.

9. Dispositif supraconducteur selon la revendication 8, selon lequel la matrice (AG) est entourée d'une enveloppe argent-magnésium (HL) durcie par dispersion.
